# EUROPÄISCHE PATENTANMELDUNG

(11) **EP 4 811 642 A1**
(43) Veröffentlichungstag der Anmeldung: **23.09.2026**
(21) Anmeldenummer: 26162291.4
(22) Anmeldetag: 04.03.2026
(51) Int. Cl.: H02M 7/5387, H02M 1/36, H02M 1/00, G01R 27/26, G01R 31/64, H02H 9/00

(54) **VERFAHREN ZUM VORLADEN VON KAPAZITIVEN LASTEN IN EINEM GLEICHSTROMNETZ UND VORLADEVORRICHTUNG FÜR EIN GLEICHSTROMNETZ**

(30) Priorität: 18.03.2025 DE 102025110487
(71) Anmelder: Weidmüller Interface GmbH & Co. KG, 32758 Detmold (DE)
(72) Erfinder: GRÜNBERG, Olaf, 32825 Blomberg (DE); AUSTERMANN, Johann, 32825 Blomberg (DE)
(74) Vertreter: Kleine, Hubertus

(57) **Zusammenfassung**

Die Erfindung betrifft ein Verfahren zum Vorladen von kapazitiven Lasten in einem Lastzweig eines Gleichstromnetzes. Das Verfahren umfasst die folgenden Schritte:
- Liefern eines Vorladestroms (I) in den Lastzweig des Gleichstromnetzes durch eine Vorladevorrichtung (10), die ausgangsseitig mit dem Lastzweig gekoppelt ist;
- Messen von mindestens zwei Werten einer Ausgangsspannung (U_{A}) der Vorladevorrichtung (10) zu mindestens zwei verschiedenen Messzeitpunkten;
- Bestimmen eines Werts einer Kapazität (C) des Lastzweigs anhand einer Höhe des Vorladestroms (I), den mindestens zwei gemessenen Werten der Ausgangsspannung (U_{A}) und einer Zeitdifferenz (dt) zwischen den mindestens zwei verschiedenen Messzeitpunkten.

Die Erfindung betrifft weiterhin eine Vorladevorrichtung (10) für ein Gleichstromnetz.

## Beschreibung

Die Erfindung betrifft ein Verfahren zum Vorladen von kapazitiven Lasten in einem Lastzweig eines Gleichstromnetz und eine Vorladevorrichtung für ein Gleichstromnetz zur Durchführung eines solchen Verfahrens.

In Industrieanlagen werden zunehmend Gleichstromnetze für eine innerbetriebliche Energieversorgung verschiedenster elektrischer und elektronischer Komponenten eingesetzt. Dabei wird aus einem Wechselspannungs-Energieversorgungsnetz über einen zentralen Gleichrichter ein Gleichstrombus mit einer Spannung im Bereich von mehreren 100 Volt (V). z.B. 650 V, gespeist. Dieser Gleichstrombus verteilt sich innerhalb des Betriebs zu verschiedenen Produktionszonen, in denen zu versorgende elektrische und elektronische Geräte im Einsatz sind, geführt. Innerhalb der Produktionszonen, die im Zusammenhang mit dem Gleichstromnetz auch Lastzonen genannt werden, werden verschiedene Geräte, beispielsweise Antriebe oder Steuerungen, über ihnen zugeordnete Schutzschalter mit dem Gleichstrombus verbunden und von ihnen mit Energie versorgt. Die Geräte selbst arbeiten gegebenenfalls bei einer geringeren Spannung, die durch einen internen oder vorgelagerten Gleichspannungswandler (DC/DC-Wandler) erzeugt wird.

Insbesondere bei einem Hinzuschalten einer Lastzone oder eines sonstigen Lastzweigs kann es zu hohen Stromflüssen kommen, die vor allem durch hohe kapazitive Lasten bedingt sind. Insbesondere DC/DC-Wandler oder Wechselrichter stellen aufgrund von Kondensatoren ihrer Zwischenkreise hohe kapazitive Lasten dar. Hohe Einschaltströme belasten die Komponenten selbst und auch das Gleichstromnetz bis hin zu Spannungseinbrüchen, die einen sicheren Betrieb anderer angeschlossener Lastzonen stören.

Aus der Druckschrift EP 3 583 688 B1 ist eine Schaltvorrichtung bekannt, die hohe Einschaltströme bei kapazitiven Lasten in Gleichstromnetzen dadurch verhindert, dass vor dem eigentlichen Einschalten eines Trennorgans dieses für eine bestimmte Zeit, die Vorladezeit genannt wird, über einen Widerstand überbrückt wird. Der Widerstand begrenzt den Stromfluss innerhalb der Vorladezeit und führt zu einem langsameren Spannungsanstieg nachgelagerter Kapazitäten. Nach Ablauf der Vorladezeit kann der Widerstand dann überbrückt werden, ohne dass zu hohe Ströme fließen.

Aus der Druckschrift EP 3 583671 B1 ist eine Weiterbildung einer derartigen Vorladevorrichtung bekannt, bei dem die Vorladung nicht verlustbehaftet über einen Widerstand erfolgt, sondern mithilfe eines stromregelnden Tiefsetzsteller. Die Vorladung über den Widerstand ist zum einen verlustbehaftet und erfordert zum anderen eine Anpassung der Größe des Widerstands an die sich im System befindenden Kapazitäten. Ändert sich die angeschlossene Kapazität, ist der Widerstand entsprechend auszutauschen. Durch eine einstellbare Stromregelung erübrigt sich das aufwendige manuelle Austauschen des Widerstands.

Dennoch ist ein manueller Eingriff zum Beispiel nach einem Systemausbau erforderlich, um den Vorladestrom an die geänderten Kapazitätswerte im Lastzweig anzupassen. Zudem besteht eine Gefahr, dass ein Systemausbau erfolgt, ohne dass die dann erforderliche Anpassung des Vorladestroms erfolgt.

Es ist eine Aufgabe der vorliegenden Erfindung, ein Verfahren zum Betreiben einer Vorladevorrichtung und eine zur Durchführung des Verfahrens geeignete Vorladevorrichtung zu schaffen, mit denen die Gefahr verringert wird, eine Vorladevorrichtung nicht korrekt an die im Lastzweig vorzuladenden Kapazitäten zu betreiben.

Diese Aufgabe wird gelöst durch ein Verfahren und eine Vorladevorrichtung mit den jeweiligen Merkmalen der unabhängigen Ansprüche. Vorteilhafte Ausgestaltungen und Weiterbildungen sind Gegenstand der abhängigen Ansprüche.

Ein erfindungsgemäßes Verfahren zum Vorladen von kapazitiven Lasten in einem Lastzweig eines Gleichstromnetzes weist die folgenden Schritte auf: Es wird ein Vorladestrom in den Lastzweig des Gleichstromnetzes durch eine Vorladevorrichtung, die ausgangsseitig mit dem Lastzweig gekoppelt ist, geliefert, wobei mindestens zwei Werte einer Ausgangsspannung der Vorladevorrichtung zu mindestens zwei verschiedenen Messzeitpunkten gemessen werden. Dann wird ein Wert einer Kapazität des Lastzweigs anhand einer Höhe des Vorladestroms, den mindestens zwei gemessenen Werten der Ausgangsspannung und einer Zeitdifferenz zwischen den mindestens zwei verschiedenen Messzeitpunkten bestimmt.

Erfindungsgemäß wird somit der während des Vorladevorgangs fließende Strom genutzt, um anhand von Spannungsmessungen den Wert der Kapazität des nachgeschalteten Lastzweig zu ermitteln. Der bestimmte Wert der Kapazität gibt Auskunft über die im Lastzweig angeordneten Kondensatoren, die beispielsweise in Zwischenkreisen von Gleichspannungswandlern oder von Wechselrichtern angeordnet sind. Ändert sich dieser Wert, ist dieses entweder ein Indiz für eine bauliche Änderung im Lastzweig oder für zum Beispiel durch Beschädigung oder durch Alterung veränderte Kondensatoren. Der Vorladeprozess kann so vorteilhaft genutzt werden, um Informationen über den angeschlossenen Lastzweig zu erhalten.

In einer vorteilhaften Ausgestaltung des Verfahrens wird der Vorladestrom während einer Vorladung durch die Vorladevorrichtung auf einen vorgegebenen konstanten Wert eingestellt und bevorzugt auf den konstanten Wert geregelt, wobei der vorgegebene konstanten Wert zur Bestimmung des Werts der Kapazität eingesetzt wird. Alternativ kann der Vorladestrom während der Vorladung gemessen werden, wobei ein gemessener Wert des Vorladestroms dann zur Bestimmung des Werts der Kapazität eingesetzt wird.

In einer weiteren vorteilhaften Ausgestaltung des Verfahrens wird der bestimmte Wert der Kapazität an eine übergeordnete Überwachungseinrichtung übermittelt. Auf diese Weise können bereits vorhandene Protokollierungs- und/oder Warneinrichtungen der übergeordnete Überwachungseinrichtung verwendet werden, um Nutzer z.B. über beobachtete Kapazitätsänderungen im Lastzweig zu informieren bzw. zu warnen.

Alternativ oder zusätzlich kann der bestimmte Wert der Kapazität innerhalb der Vorladevorrichtung selbst ausgewertet werden.

In beiden Fällen kann vorgesehen sein, den bestimmte Wert der Kapazität mit einem vorgegebenen Wert oder mit einem zuvor bestimmten Wert der Kapazität zu vergleichen, wobei eine Warnmeldung ausgegeben wird, wenn eine Abweichung größer als ein vorgegebener Grenzwert ist.

Weiter kann der bestimmte Wert genutzt werden, um Parameter der Vorladung, insbesondere die Höhe des Vorladestroms, abhängig von dem bestimmten Wert der Kapazität einzustellen. Dabei kann der Wert der Kapazität in einem ersten Vorladevorgang bestimmt werden und es kann vorgesehen sein, anhand des Wertes der Kapazität eingestellten Parameter für einen folgenden Vorladevorgang zu nutzen. Auf diese Weise wird automatisch sichergestellt, dass nachfolgende Vorladevorgänge mit optimal passenden Parametern durchgeführt werden. Alternativ ist es auch möglich, den Wert der Kapazität in einem ersten Zeitabschnitt der Vorladezeit eines Vorladevorgangs zu bestimmen und die anhand des Wertes der Kapazität eingestellten Parameter für einen folgenden zweiten Zeitabschnitt der Vorladezeit desselben Vorladevorgangs zu nutzen. In dem Fall wird jeder Vorladevorgang zumindest für den zweiten Zeitabschnitt mit optimal passenden Parametern durchgeführt werden. Der zweite Zeitabschnitt kann dabei mindestens 50 %, bevorzugt auch über 70 % oder über 90 % der gesamten Vorladezeit betragen.

Eine erfindungsgemäße Vorladevorrichtung umfasst einen Strombegrenzer zum Liefern eines Vorladestroms in einen Lastzweig des Gleichstromnetzes, der mit einem Ausgang der Vorladevorrichtung gekoppelt ist, und ein Spannungsmessmodul zum Messen von mindestens zwei Werten einer Ausgangsspannung der Vorladevorrichtung zu mindestens zwei verschiedenen Messzeitpunkten, sowie eine Steuereinheit, die dazu eingerichtet ist, einen Wert einer Kapazität des Lastzweigs anhand einer Höhe des Vorladestroms, den mindestens zwei gemessenen Werten der Ausgangsspannung und einer Zeitdifferenz zwischen den mindestens zwei verschiedenen Messzeitpunkten zu bestimmen. Es ergeben sich die im Zusammenhang mit dem Vorladeverfahren zuvor beschriebenen Vorteile.

In einer vorteilhaften Ausgestaltung weist die Vorladevorrichtung ein Strommessmodul zum Messen einer Höhe des Vorladestroms auf und/oder ein weiteres Spannungsmessmodul zum Messen von einer Höhe einer Eingangsspannung, wobei die Steuereinheit weiter dazu eingerichtet ist, einen internen oder externen Überbrückungsschalter anzusteuern, der parallel zu dem Strombegrenzer geschaltet ist.

Weiter ist bevorzugt der Strombegrenzer im Hinblick auf die Höhe des Vorladestroms von der Steuereinheit ansteuerbar, wobei die Steuereinheit dazu eingerichtet ist, die Höhe des Vorladestroms abhängig von dem bestimmten Wert der Kapazität einzustellen. Auf dieser Weise kann der ermittelte Wert der Kapazität im Lastkreis genutzt werden, um Parameter des Vorladevorgangs, insbesondere die Höhe des Vorladestrom, optimal an den Lastzweig anzupassen.

Die Erfindung wird nachfolgend anhand von Ausführungsbeispielen mithilfe von Figuren näher erläutert. Die Figuren zeigen:
- Fig. 1: ein Blockschaltbild eines Teils eines Gleichstromnetzes mit Vorladevorrichtung;
- Fig. 2, 3: jeweils ein Blockschaltbild eines Ausführungsbeispiels einer Vorladevorrichtung;
- Fig. 4: ein Ablaufdiagramm eines Verfahrens zum Vorladen von kapazitiven Lasten in einem Gleichstromnetz; und
- Fig. 5: ein schematisches Diagramm, in dem der Verlauf von Spannungen, gemessen bei dem in Figur 4 dargestelltem Verfahren, wiedergegeben ist.

In allen Figuren zeigen gleiche Bezugszeichen gleiche oder gleichwirkende Elemente. Aus Gründen der Übersichtlichkeit ist nicht in jeder Figur jedes Element mit einem Bezugszeichen versehen.

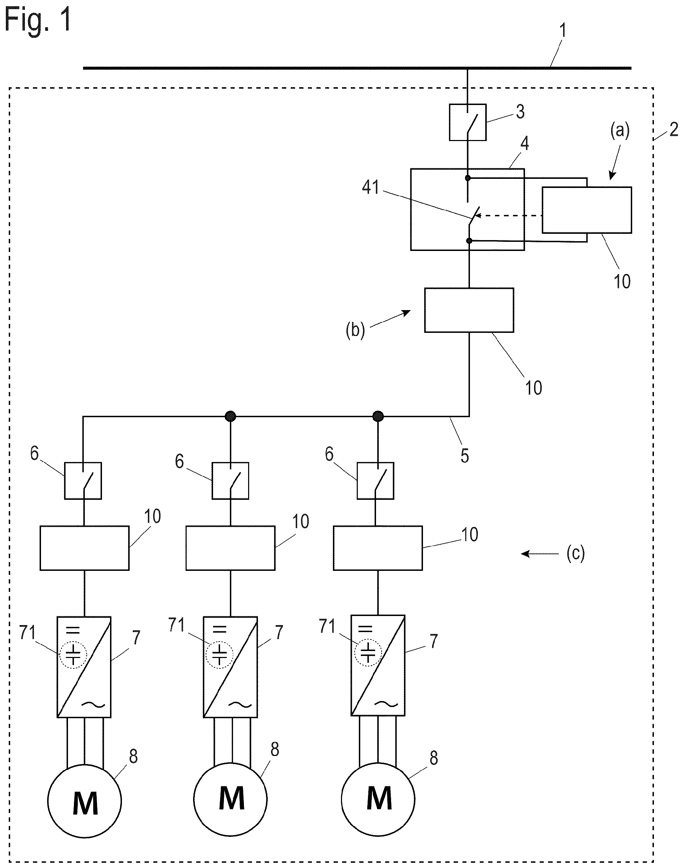

Figur 1 zeigt zunächst einen typischen Aufbau eines Ausschnitts eines Gleichstromnetzes zur Versorgung einer Industrieanlage in einem Blockschaltbild. Das Gleichstromnetz umfasst einen primären Gleichstrombus 1, der in der Regel über einen Mittelspannungsanschluss und einen entsprechenden Transformator mit einem übergeordneten Energieversorgungsnetz verbunden ist (nicht dargestellt in Fig. 1). Zwischen dem Energieversorgungsnetz und dem Gleichstrombus 1 sind neben dem genannten Transformator ein Gleichrichter, üblicherweise ein mit aktiv angesteuerten Schaltelementen arbeitender Gleichrichter sowie Schutz- und Sicherheitsorgane angeordnet.

An den primären Gleichstrombus 1 sind üblicherweise mehrere Lastzonen 2 angeschlossen, von denen hier beispielhaft eine wiedergegeben ist. Die Lastzone 2 ist über einen Wartungsschalter 3 an den primären Gleichstrombus 1 angekoppelt, dem ein Schutzschalter 4 nachgeschaltet ist. Der Schutzschalter 4 weist ein ansteuerbares Schaltorgan 41 auf, das entsprechend gesteuert zum Beispiel bei Überlast und/oder bei nachgelagerten Isolationsproblemen abschaltet.

An den Schutzschalter 4 schließt sich ein sekundärer Gleichstrombus 5 an, der Strom an verschiedene Anlagenkomponenten verteilt, von denen hier beispielhaft drei Motoren 8 angegeben sind, die jeweils von einem Wechselrichter 7 angesteuert werden. Zum Unterbrechen der Stromzufuhr zu jeder der Einheiten aus Wechselrichter 7 und zugeordnetem Motor 8 ist jedem Wechselrichter 7 ein Trennschalter 6 vorgeschaltet, über den die genannte Anordnung an den sekundären Gleichstrombus 5 ankoppelbar ist.

Jeder der Wechselrichter 7 weist funktionsbedingt einen Zwischenkreis 71 mit Zwischenkreiskondensatoren auf. Die Kapazitäten der Kondensatoren der Wechselrichter 7 addieren sich zu einer Gesamtkapazität im sekundären Gleichstromkreis 5, die beim Schließen des Wartungsschalters 3 zunächst aufgeladen werden muss. Die bei einem unmittelbaren Schließen des Wartungsschalters 3 (oder auch jedes Trennschalters 6) fließenden und anfangs sehr hohen Ladeströme sind für die Kondensatoren selbst lebensdauervermindernd und können sich in Summe zu einem Strom addieren, der die Abschaltstromschwelle des Schutzschalters 4 übersteigt und der unter Umständen negative Rückwirkungen auf den primären Gleichstrombus 1 hat, z.B. Spannungseinbrüche.

Zu diesem Zweck werden Vorladevorrichtungen 10 eingesetzt, die rein beispielhaft in Figur 1 in verschiedenen Varianten (a) bis (c) an verschiedenen möglichen Positionen angeordnet sind.

Beispielsweise kann in einer ersten Variante (a) eine Vorladevorrichtung 10 am Schutzschalter 4 angeordnet sein und mit dem Schutzschalter 4 zusammenwirken. Beim Einschalten des Wartungsschalters 3 ist der Schutzschalter 4 zunächst geöffnet und ein Stromfluss in den sekundären Gleichstrombus 5 erfolgt kontrolliert über die Vorladevorrichtung 10. Nachdem sich auf dem sekundären Gleichstrombus 5 eine Spannung aufgebaut hat, die sich der Höhe der Spannung auf dem primären Gleichstrombusses 1 angenähert hat, wird schließlich das Schaltorgan 41 des Schutzschalters 4 eingeschaltet und damit die Vorladevorrichtung 10 überbrückt.

In einer dazu alternativen zweiten Variante (b) kann die Vorladevorrichtung 10 auch dem Schutzschalter 4 nachgeordnet sein, wobei in dem Fall ein zunächst trennender und dann überbrückender Schalter in der Vorladevorrichtung 10 selbst angeordnet ist.

Weiter können Vorladevorrichtungen 10 auch alternativ oder zusätzlich individuell vor einem der oder jedem Wechselrichter 7 angeordnet sein, wie in Variante (c) dargestellt ist. In dem Fall kann eine Vorladung der Kapazitäten des entsprechend nachgeordneten Wechselrichters 7 auch erfolgen, wenn dieser unabhängig von den anderen Wechselrichtern 7 über den ihm zugeordneten Trennschalter 6 zeitweise, zum Beispiel für Wartungsarbeiten oder für längere Betriebspausen, vom sekundären Gleichstromkreis 5 getrennt wurde.

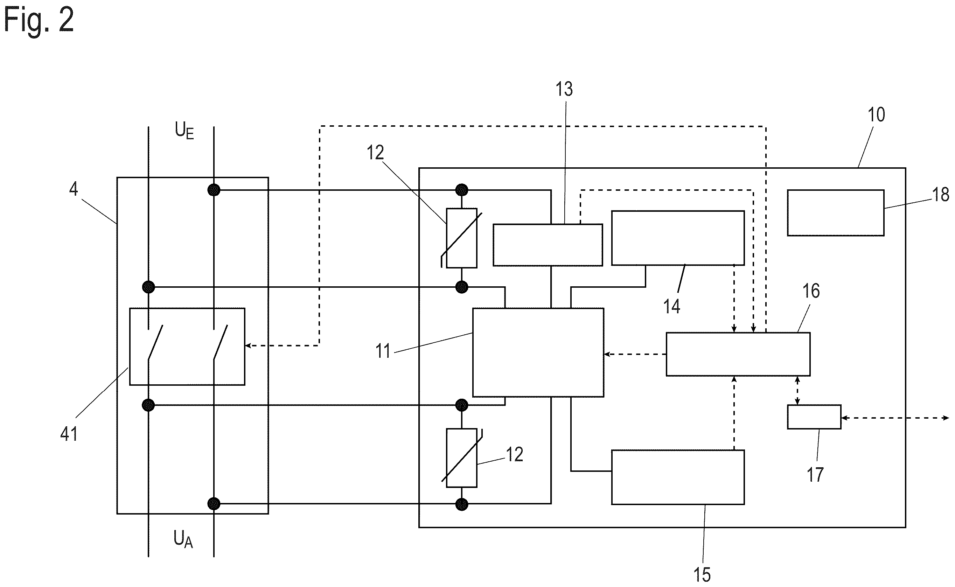

In Figur 2 ist ein erstes Ausführungsbeispiel einer Vorladevorrichtung 10 gezeigt, die für die Einbausituation der ersten Variante (a) gemäß Figur 1 geeignet ist, bei der die Vorladevorrichtung 10 unmittelbar einem Schutzschalter 4 zugeordnet ist.

Der Schutzschalter 4 weist neben hier nicht dargestellter Ansteuerelektronik das ansteuerbare Schaltorgan 41 auf, beispielsweise einen Schütz oder ein Relais oder ein Halbleiterschaltorgan. Symbolisch ist das Schaltorgan hier mit einem 2-poligen mechanischer Kontaktsatz dargestellt, womit aber Halbleiterschaltorgane ausdrücklich eingeschlossen sein sollen.

Mit diesem Schaltorgan 41 kann der nachgelagerte Abschnitt der Lastzone 2 bei Überlast und/oder Isolationsproblemen vom primären Gleichstrombus 1 getrennt werden. Die am Schutzschalter 4 anliegende Spannung des primären Gleichstrombus 1 wird als Eingangsspannung U_{E} bezeichnet und die am Ausgang liegende Spannung des sekundären Gleichstrombusses 5 als Ausgangsspannung U_{A}. Der sich an eine Vorladevorrichtung 10 anschließende Teil des Gleichstromnetzes wird nachfolgend auch als Lastzweig bezeichnet.

Ein- und ausgangsseitig ist der Schutzschalter 4 mit der Vorladevorrichtung 10 verbunden, wobei beidseitig ein hier nicht dargestellter EMV (Elektromagnetische Verträglichkeit) -Filter zwischengeschaltet sein kann.

Die Vorladevorrichtung 10 weist einen Strombegrenzer 11 auf, der eingangsseitig mit dem primären Gleichstrombus 1 verbunden ist und ausgangsseitig mit dem sekundären Gleichstrombus 5 und dabei das Schaltorgan 41 umgeht. Der Strombegrenzer 11 begrenzt während der Vorladung einen auf dem sekundären Gleichstrombus 5 fließenden Vorladestrom I. In einem einfachsten Fall könnte ein Widerstand als Strombegrenzer 11 dienen. Bei den vorliegenden Ausführungsbeispielen wird dagegen ein ansteuerbarer Strombegrenzer 11 eingesetzt, mit dem der Vorladestrom I auf einen vorgebbaren maximalen Wert eingestellt werden kann, beispielsweise über einen pulsweitenmoduliert (PWM) angesteuerten Schalter, z.B. innerhalb eines Tiefsetzstellers.

Zum Schutz vor Überspannungen können ein- und/oder ausgangsseitig Schutzelemente, beispielsweise Varistoren 12 vorhanden sein.

Weiter ist - in diesem Fall eingangsseitig - ein Strommessmodul 13 vorhanden, das den vom primären Gleichstrombus 1 in den sekundären Gleichstrombus 5 und damit in die Lastzone 2 fließenden Strom misst. Zudem sind ein- und ausgangsseitig Spannungsmessmodule 14 bzw. 15 vorhanden, die die Höhe der Eingangsspannung U_{E} bzw. der Ausgangsspannung U_{A} ermitteln und einen ermittelten Spannungswert analog oder digital an eine Steuereinheit 16 übertragen. Weiter wird der gemessener Stromwert von dem Strommessmodul 13 an die Steuereinheit 16 übergeben.

Die Steuereinheit 16 wiederum steht über einen Steuerausgang mit dem Strombegrenzer 11 in einer analogen oder digitalen Kommunikationsverbindung, über die der Strombegrenzer 11 von der Steuereinheit 16 gesteuert werden kann. Zudem ist eine Kommunikationsverbindung zwischen der Steuereinheit 16 und dem Schutzschalter 4 ausgebildet, über die die Steuereinheit 16 den Schaltzustand des Schaltorgans 41 beeinflussen kann. Aufgrund der Kopplung der Vorladevorrichtung 10 mit dem Schutzschalter 4 kann das Schaltorgan 41 als externer Überbrückungsschalter für den Strombegrenzer 11 eingesetzt werden.

Die Steuereinheit 16 selbst kann über ein optionales Kommunikationsmodul 17 mit einer übergeordneten Steuerungs- und/oder Überwachungseinheit verbunden sein. Weiter ist zur Versorgung der genannten Komponenten in der Vorladevorrichtung 10 ein DC/DC-Wandler 18 angeordnet, der die über den Gleichstrombus 1 zugeführte hohe Spannung in eine Gleichspannung-Schutzkleinspannung von beispielsweise 24 V wandelt.

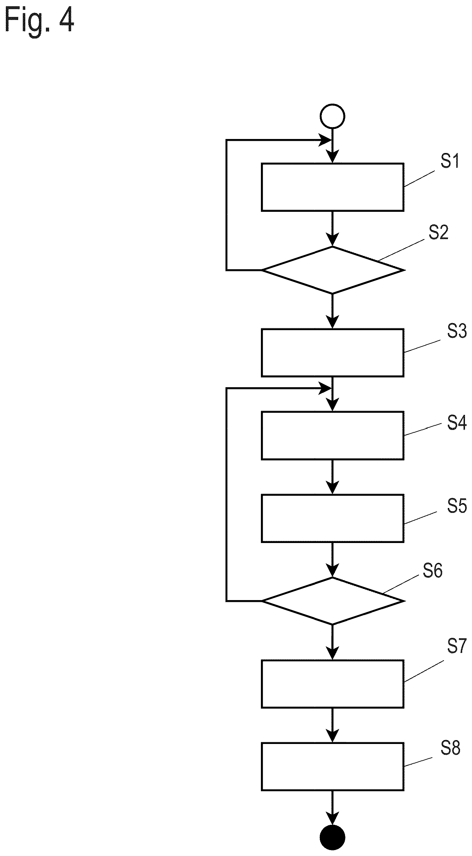

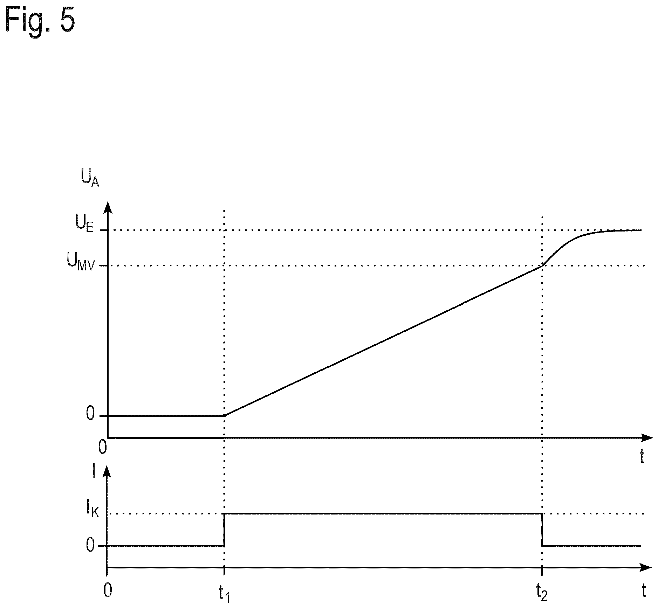

Im Betrieb wird, wie später im Zusammenhang mit den Figuren 4 und 5 noch näher erläutert wird, von der Vorladevorrichtung 10 mithilfe des eingangsseitigen Spannungsmessmoduls 14 die am Schutzschalter 4 anliegende Eingangsspannung U_{E} gemessen. Es wird detektiert, wenn diese Eingangsspannung U_{E} eingeschaltet wird, beispielsweise da der in Figur 1 gezeigte Wartungsschalter 3 eingeschaltet wird. Die Vorladevorrichtung 10 erhöht über den steuerbaren Strombegrenzer 11 dann langsam die Ausgangsspannung, um Kapazitäten in der Lastzone 2 langsam vorzuladen. Dabei kann der Strombegrenzer 11 von der Steuereinrichtung 16 beispielsweise so gesteuert werden, dass die Vorladung mit einem konstanten Strom erfolgt. Alternativ oder zusätzlich kann auch die Ausgangsspannung U_{A} über das ausgangsseitige Spannungsmessmodul 15 während des Vorladevorgangs betrachtet werden und der Strombegrenzer 11 so angesteuert werden, dass ein vorgegebener Spannungsgradient erreicht und/oder nicht überschritten wird.

Erst wenn die ausgangsseitige Spannungsmessung über das Spannungsmessmodul 15 anzeigt, dass ein bestimmter Spannungsschwellwert ausgangsseitig erreicht ist, schaltet die Steuereinheit 16 über die zuvor beschriebene Kommunikationsverbindung das Schaltorgan 41 ein.

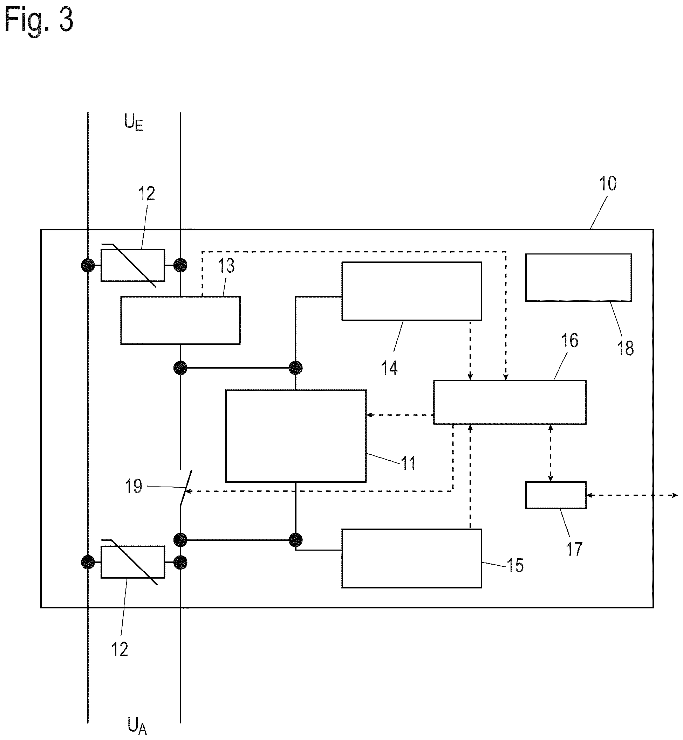

Figur 3 zeigt eine Ausgestaltung der Vorladevorrichtung 10 für eine Verwendung unabhängig von dem Schutzschalter 4, also beispielsweise für eine Verwendung in den alternativen gezeigten Positionen gemäß Figur 1, also dem Schutzschalter 4 nachgeordnet oder unmittelbar dem Wechselrichter 7 vorgeschaltet.

Der Grundaufbau der Vorladevorrichtung 10 bei der Figur 3 entspricht dem der Figur 2, wobei jedoch die Vorladevorrichtung 10 in diesem Fall einen separaten internen oder ihr extern zugeordneten Überbrückungsschalter 19 aufweist, der ebenso wie beim Beispiel der Figur 2 das Schaltorgan 41 von der Steuereinheit 16 eingeschaltet werden kann, wenn die Ausgangsspannung U_{A} des Strombegrenzers 11 beim Vorladevorgang ein bestimmtes Spannungsniveau erreicht hat.

Erfindungsgemäß werden die während des Vorladevorgangs erfassten Informationen über den Vorladestrom I und die sich am Ausgang des Strombegrenzers 11 ergebende Vorladespannung, d.h. die Ausgangsspannung U_{A}, genutzt, um einen Wert einer Kapazität C von Kondensatoren in dem nachgeschalteten Lastzweig zu ermitteln, was nachfolgend im Zusammenhang mit den Figuren 4 und 5 noch näher erläutert wird.

Der bestimmte Wert der Kapazität C gibt Auskunft über die im Lastzweig, beispielsweise in den Zwischenkreisen 71 angeordneten Kondensatoren. Ändert sich dieser Wert, ist dieses entweder ein Indiz für eine bauliche Änderung im Lastzweig oder für zum Beispiel durch Beschädigung oder durch Alterung veränderte Kondensatoren.

Der bestimmte Wert der Kapazität C kann zum einen intern von der Vorladevorrichtung 10 verwendet werden, um den Vorladestrom I anzupassen. Zum anderen kann ein veränderter Kapazitätswert über das Kommunikationsmodul 18 an die übergeordnete Überwachungs- und Steuereinrichtung weitergeleitet werden, die eine entsprechende Information oder Warnung an den Benutzer ausgibt.

Ein Ausführungsbeispiel eines erfindungsgemäßen Verfahrens zur Bestimmung des Werts der Kapazität C durch die Vorladevorrichtung 10 wird nachfolgend anhand eines Ablaufdiagramms in Figur 4 und beispielhafter Messwerte von Strom und Spannung während des Vorladevorgangs in Figur 5 näher erläutert.

Das erfindungsgemäße Verfahren kann beispielsweise in dem in Figur 1 gezeigten Teil des Gleichstromnetzes durch die in den Figuren 2 oder 3 gezeigte Vorladevorrichtung 10 durchgeführt werden. Es wird beispielhaft nachfolgend mit Verweis auf die dort genannten Elemente und Bezugszeichen beschrieben.

Bei dem Ablaufdiagramm der Figur 4 wird davon ausgegangen, dass eine Vorladevorrichtung 10 an das primäre Gleichstromnetz 1 angeschlossen ist und am Eingang der Vorladevorrichtung 10 eine Eingangsspannung der Höhe U_{E} anliegt. Beispielhaft sei zu Beginn des Verfahrens die Spannung U_{E} =0 oder verglichen mit dem nachfolgend im Zusammenhang mit dem Schritt S2 genannten Spannungsgrenzwert zumindest sehr klein.

In einem ersten Schritt S1 des Verfahrens wird die Eingangsspannung U_{E} gemessen, beispielsweise mithilfe des Spannungsmessmoduls 14 aus den Ausführungsbeispielen der Figuren 2 und 3.

In einem folgenden Schritt S2 wird die gemessene Eingangsspannung U_{E} mit einem Grenzwert verglichen, der beispielsweise bei etwa 70% der Nominalspannung von U_{E} liegt, die im Arbeitsbetrieb des Gleichstrombusses 1 herrscht. Ist dieser Spannungsgrenzwert noch nicht erreicht, verzweigt das Verfahren zurück zum Schritt S1 um die Eingangsspannung U_{E} erneut und damit quasi kontinuierlich zu messen.

Wird der Spannungsgrenzwert im Schritt S2 von der Eingangsspannung U_{E} erreicht oder überschritten, wird das Verfahren mit einem Schritt S3 fortgesetzt, in dem eine vorgegebene Wartezeit abgewartet wird.

Bei einem Einsatz der Vorladevorrichtung 10 in den Einbauvarianten (a) und (b) gemäß Figur 1 wird somit in den Schritten S1 und S2 überprüft, ob das Gleichspannungsnetz eingeschaltet wird und der primäre Gleichstrombus 1 mit Spannung beaufschlagt wird. Bei einem Einsatz der Vorladevorrichtung 10 in der Einbauvariante (c) gemäß Figur 1 wird entsprechend geprüft, ob der sekundäre Gleichstrombus 5 mit Spannung beaufschlagt wird.

In beiden Fällen baut sich aufgrund angeschlossener Kapazitäten und auch aufgrund einer gegebenenfalls für den Gleichstrombus 1 oder 5 vorhandenen weiteren Vorladevorrichtung die Spannung langsam auf. Die Wartezeit im Schritt S3 verhindert, dass die Vorladevorrichtung 10, die das hier beschriebene Verfahren ausführt, mit diesem Verfahren nicht startet, bevor die Spannung auf dem eingangsseitigen Gleichstrombus 1, 5 ihren Nominalspannungswert erreicht hat. Der im Schritt S2 gewählte Spannungsgrenzwert und die Wartezeit sind dabei aufeinander abgestimmt. Alternativ ist denkbar, auf die Wartezeit im Schritt S3 zu verzichten und den Spannungsgrenzwert im Schritt S2 auf oder sehr nah an die Nominalspannung für den eingangsseitigen Gleichstrombus 1, 5 zu legen. Eine solche Anordnung ist allerdings weniger fehlertolerant gegenüber einer Schwankung der Nominalspannung auf dem Gleichstrombus 1, 5.

Nach dem Ablauf der Wartezeit im Schritt S3 startet in einem Schritt S4 die Vorladung des am Ausgang der Vorladevorrichtung 10 angeschlossenen Lastzweigs, beispielweise der Lastzone 2, wenn die dargestellte Vorladevorrichtung 10 in der Variante (a) oder (b) der Figur 1 betrieben wird. Wenn die Position der hier beschriebenen Vorladevorrichtung 10 der Variante (c) gemäß Figur 1 entspricht, ist der ausgangsseitige Lastzweig der Vorladevorrichtung 10 entsprechend der einzelne Wechselrichter 7.

Zur Vorladung wird der Strombegrenzer 11 verwendet, der beispielsweise so geregelt sein kann, dass ein (möglichst) konstanter Vorladestrom I fließt. Der Vorladestrom I wird von dem Strommessmodul 13 gemessen und der gemessene Wert wird von der Steuereinheit 16 ausgewertet und kann zur Regelung des Strombegrenzers 11 eingesetzt werden. In anderen Ausgestaltungen können auch nicht konstante Vorladeströme I vorgesehen sein.

Figur 5 zeigt in einem schematischen Diagramm den Verlauf des Vorladestroms I in Abhängigkeit einer Zeit t im unteren Bereich des Diagramms. Im oberen Bereich des Diagramms ist die Ausgangsspannung Uₐ auf gleicher Zeitskala wiedergegeben.

In dem Diagramm ist zu erkennen, dass sowohl Vorladestrom I als auch Ausgangsspannung Uₐ bis zu einem Zeitpunkt t₁ gleich 0 sind. Wenn zum Zeitpunkt t=0 die Eingangsspannung U_{A} gerade den Grenzwert im Schritt S2 überschritten hat, gibt der Zeitpunkt t=t₁ das Ende der Wartezeit des Schrittes S3 an.

Ab dem Zeitpunkt t=t₁ wird in dem dargestellten Beispiel der Vorladestrom I auf einen konstanten Wert Iₖ geregelt und die die Ausgangsspannung U_{A} steigt entsprechend - konstante Kapazität im Lastzweig angenommen - linear an.

In einem folgenden Schritt S5 wird die Ausgangsspannung U_{A} gemessen und ihr Wert zeitabhängig, d.h. z.B. in Wertepaaren mit der Zeit t, abgespeichert. Alternativ, insbesondere wenn kein konstanter Vorladestrom I_{K} eingesetzt wird, werden zusätzlich von dem Strommessmodul 13 gemessene Werte des Vorladestroms I zeitabhängig abgespeichert.

Der aktuelle Wert der gemessenen Ausgangsspannung U_{A} wird in einem folgenden Schritt S6 mit einem weiteren Grenzwert verglichen, der eine maximale Vorladespannung U_{MV} angibt. Solange die aktuell gemessene Ausgangsspannung U_{A} kleiner ist als der Grenzwert der maximalen Vorladespannung U_{MV} verzweigt das Verfahren zurück zum Schritt S4, wodurch die Vorladung fortgesetzt wird.

Erreicht oder übersteigt die aktuell gemessene Ausgangsspannung U_{A} den Grenzwert der maximalen Vorladespannung U_{MV} wird das Verfahren mit einem Schritt S7 fortgesetzt, in dem die Vorladung mit dem konstanten Strom I_{K} durch den Strombegrenzer 11 beendet wird und in dem entweder das Schaltorgan 41 (Figur 2) oder der Überbrückungsschalter 19 (Figur 3) von der Steuereinheit 16 so angesteuert wird, dass es bzw. er schließt und den Strombegrenzer 11 überbrückt.

Im Diagramm der Figur 5 geschieht dies zu einem Zeitpunkt t₂, ab dem der Vorladestrom I wieder auf Null absinkt und die Ausgangsspannung U_{A} in einer annähernd exponentiellen Kurve auf den Endwert U_{E} ansteigt. Es wird angemerkt, dass der Abfall des Vorladestroms I sich in der Form nur beim Ausführungsbeispiel der Figur 2 zeigen wird, da in diesem Ausführungsbeispiel das Strommessmodul 13 nur den durch den Strombegrenzer 11 fließenden Strom anzeigt. Beim Ausführungsbeispiel der Figur 3 wird auch der durch den Überbrückungsschalter 19 fließende Strom von dem Strommessmodul 13 gemessen, weswegen der Strom in dem Fall nicht auf 0 absinkt. Weiter wird angemerkt, dass der exponentielle Anstieg in der Figur 5 zur Verdeutlichung gestreckt dargestellt ist. Typischerweise wird der Anstieg steiler und schneller erfolgen, da der Innenwiderstand des Schaltorgans 41 beziehungsweise des Überbrückungsschalters 19 in der Regel so klein ist, dass ein höherer Strom fließt und die Ausgangsspannung U_{A} sich schneller an die Eingangsspannung U_{E} angleicht.

Der eigentliche Vorladevorgang ist mit dem Schritt S7 abgeschlossen. In einem Folgeschritt S8 werden die im Schritt S5 aufgezeichneten Messwerte für die Ausgangsspannung U_{A} zusammen mit dem für den Schritt S4 vorgegebenen konstanten Vorladestrom I_{K} ausgewertet, um den Wert der Kapazität C des ausgangsseitigen Lastzweigs zu ermitteln. Alternativ und insbesondere, wenn kein konstanter Vorladestrom I_{K} genutzt wurde, werden stattdessen die ebenfalls zeitabhängigen Werte des Vorladestroms I zu Auswertung herangezogen.

Der Wert der Kapazität C bei einem Ladevorgang ergibt sich aus dem differentiellen Quotienten von geflossener Ladung dQ und der Spannungsänderung dU: C = dQ / dU. Im dargestellten Fall eines konstanten Vorladestroms I_{K} ergibt sich C = I_{K} dt/dU, weswegen die Kapazität Q aus der Steigung des geraden Verlaufs der Ausgangsspannung zwischen dem Zeitpunkt t₁ und t₂ und dem bekannten konstanten Vorladestroms I_{K} bestimmt werden.

Falls in einer alternativen Ausgestaltung der Vorladestrom I während des Vorladeprozesses nicht konstant gehalten wird und in dem Schritt S5 ein aktuell gemessener Wert des Vorladestroms I ebenfalls als Funktion der Zeit t abgespeichert wird, kann eine aktuelle Kapazität für jeden Zeitpunkt während des Vorladevorgangs bestimmt. Daraus lässt sich dann eine mittlere Kapazität im Lastzweig im Schritt S8 ermitteln.

Die ermittelte Kapazität C wird im Schritt S7 ausgegeben, beispielsweise über das Kommunikationsmodul 17 der Vorladevorrichtung 10 und kann von einer übergeordneten Überwachungseinrichtung erfasst und bewertet werden. Wird beispielsweise eine Veränderung der ermittelten Kapazität C gegenüber einem zuletzt bestimmten Wert bei einem zurückliegenden Vorladevorgang erkannt, deutet dieses auf eine Veränderung entweder der Anlagenkonstellation hin oder auf defekte oder sich zumindest verändernde Kondensatoren innerhalb der Lastzone.

Auch ist denkbar, die Auswertung des Kapazitätswerts innerhalb der Vorladevorrichtung 10 selbst zu nutzen, um Parameter der Vorladung, beispielsweise die Höhe des verwendeten Vorladestroms **I,** anzupassen.

Dabei kann vorgesehen sein, einen wie zuvor beschrieben im Schritt S7 ermittelten Wert für die Kapazität C zu verwenden, um Parameter des Vorladevorgangs, beispielsweise die Höhe des konstanten Vorladestroms I_{K}, für einen nächsten Vorladevorgang anzupassen.

Es ist in einer alternativen Ausgestaltung des in Figur 4 gezeigten Verfahrens auch denkbar, einen Wert für die Kapazität C bereits während des Vorladevorgangs im Schritt S5 zu berechnen und diesen berechneten Wert der Kapazität C zur Anpassung der Parameter der Vorladung, insbesondere des konstanten Vorladestroms I_{K}, einzusetzen. Beispielsweise kann vorgesehen sein, die Vorladung zunächst mit dem zuletzt verwendeten konstanten Vorladestrom I_{K} zu beginnen und nach einer bestimmten Zeit, die zum Beispiel 10 % der erwarteten Vorladezeit beträgt, den Wert der Kapazität C zu ermitteln und für die verbleibende Vorladezeit dann einen angepassten Wert des konstanten Vorladestroms I_{K} zu benutzen. Gegebenenfalls kann vorgesehen sein, die Anpassung des Vorladestroms nicht nur einmal innerhalb eines vor Ladevorgangs vorzunehmen, sondern auch zwei- oder mehrfach.

Um die Kapazität C bereits während des Vorladevorgangs zu bestimmen und Parameter des Vorladevorgangs anzupassen, wird bevorzugt eine hohe Abtastrate bei der Messung der Ausgangsspannung U_{A} und gegebenenfalls des Vorladestroms I zu verwenden, beispielsweise eine Abtastrate über 1 Kilohertz (kHz), also mit mehr als 1000 Abtastung pro Sekunde.

In einer Weiterbildung des beschriebenen Verfahrens und auch der beschriebenen Vorladevorrichtung 10 kann zudem vorgesehen sein, weitere Spannungen während des Vorladevorgangs zu messen und auszuwerten. Insbesondere können Spannungen des positiven bzw. negativen Pols (Leiters) der Eingangsspannung U_{E} gegenüber einer Schutzerde (PE) gemessen werden und eine Symmetrie der Eingangsspannung U_{E} gegenüber der Schutzerde ermittelt werden. Eine sich zeigende Asymmetrie, die oberhalb eines festgelegten Grenzwert liegt, kann einen Isolationsfehler im Gleichstromnetz anzeigen. Insbesondere wenn sich die Asymmetrie während des Vorladevorgangs verändert, deutet dieses auf einen Isolationsfehler im Lastzweig hin.

Die Bestimmung der Asymmetrie der Eingangsspannung U_{E} kann zeitlich auch zusätzlich unabhängig von einem Vorladevorgang durchgeführt werden, wodurch die Vorladevorrichtung 10 auch unabhängig vom Vorladevorgang die Funktionalität eines Isolationswächters dem Gleichstromnetz ausführt.

Vorteilhaft können so in der Vorladevorrichtung 10 vorhandene Komponenten wie beispielsweise die Steuereinheit 16 und die Kommunikationsverbindung 17 auch für die Zwecke der Isolationsüberwachung genutzt werden.

### Bezugszeichenliste

- 1: Gleichstrombus
- 2: Lastzone
- 3: Wartungsschalter
- 4: Schutzschalter
- 41: Schaltorgan
- 5: Sekundärer Gleichstrombus
- 6: Trennschalter
- 7: Wechselrichter
- 71: Zwischenkreiskondensator
- 8: Motor

- 10: Vorladevorrichtung
- 11: Strombegrenzer
- 12: Varistor
- 13: Strommessmodul
- 14, 15: Spannungsmessmodul
- 16: Steuereinheit
- 17: Kommunikationsmodul
- 18: DC/DC-Wandler
- 19: Überbrückungsschalter

- U_{E}: Eingangsspannung
- U_{A}: Ausgangsspannung
- U_{MV}: maximale Vorladespannung

- I: Vorladestrom
- I_{K}: konstanter Vorladestrom

- C: Kapazität

## Patentansprüche

1. Verfahren zum Vorladen von kapazitiven Lasten in einem Lastzweig eines Gleichstromnetzes, aufweisend die folgenden Schritte:
- Liefern eines Vorladestroms (I) in den Lastzweig des Gleichstromnetzes durch eine Vorladevorrichtung (10), die ausgangsseitig mit dem Lastzweig gekoppelt ist;
- Messen von mindestens zwei Werten einer Ausgangsspannung (U_{A}) der Vorladevorrichtung (10) zu mindestens zwei verschiedenen Messzeitpunkten;
- Bestimmen eines Werts einer Kapazität (C) des Lastzweigs anhand einer Höhe des Vorladestroms (I), den mindestens zwei gemessenen Werten der Ausgangsspannung (U_{A}) und einer Zeitdifferenz (dt) zwischen den mindestens zwei verschiedenen Messzeitpunkten.

2. Verfahren nach Anspruch 1, bei dem der Vorladestrom (I) während einer Vorladung durch die Vorladevorrichtung (10) auf einen vorgegebenen konstanten Wert (I_{K}) eingestellt wird, wobei der vorgegebene konstanten Wert (I_{K}) zur Bestimmung des Werts der Kapazität (C) eingesetzt wird.

3. Verfahren nach Anspruch 2, bei dem der Vorladestrom (I) während einer Vorladung durch die Vorladevorrichtung (10) auf den konstanten Wert (I_{K}) geregelt wird.

4. Verfahren nach einem der Ansprüche 1 bis 3, bei dem der Vorladestrom (I) während der Vorladung gemessen wird, wobei ein gemessener Wert des Vorladestroms (I) zur Bestimmung des Werts der Kapazität (C) eingesetzt wird.

5. Verfahren nach einem der Ansprüche 1 bis 4, bei dem der bestimmte Wert der Kapazität (C) an eine übergeordnete Überwachungseinrichtung übermittelt wird.

6. Verfahren nach einem der Ansprüche 1 bis 5, bei dem der bestimmte Wert der Kapazität (C) innerhalb der Vorladevorrichtung (10) selbst ausgewertet wird.

7. Verfahren nach Anspruch 5 oder 6, bei dem der bestimmte Wert der Kapazität (C) mit einem vorgegebenen Wert oder mit einem zuvor bestimmten Wert der Kapazität (C) verglichen wird, wobei eine Warnmeldung ausgegeben wird, wenn eine Abweichung größer als ein vorgegebener Grenzwert ist.

8. Verfahren nach einem der Ansprüche 5 bis 7, bei dem Parameter der Vorladung, insbesondere die Höhe des Vorladestroms (I), abhängig von dem bestimmten Wert der Kapazität (C) eingestellt werden.

9. Verfahren nach Anspruch 8, bei dem der Wert der Kapazität (C) in einem ersten Vorladevorgang bestimmt wird und die anhand des Wertes der Kapazität (C) eingestellten Parameter für einen folgenden Vorladevorgang gelten.

10. Verfahren nach Anspruch 8, bei dem der Wert der Kapazität (C) in einem ersten Zeitabschnitt der Vorladezeit eines Vorladevorgangs bestimmt wird und die anhand des Wertes der Kapazität (C) eingestellten Parameter für einen folgenden Zeitabschnitt der Vorladezeit desselben Vorladevorgangs gelten.

11. Vorladevorrichtung (10) für ein Gleichstromnetz, aufweisend
- einen Strombegrenzer (11) zum Liefern eines Vorladestroms (I) in einen Lastzweig des Gleichstromnetzes, der mit einem Ausgang der Vorladevorrichtung gekoppelt ist;
- ein Spannungsmessmodul (15) zum Messen von mindestens zwei Werten einer Ausgangsspannung (U_{A}) der Vorladevorrichtung (10) zu mindestens zwei verschiedenen Messzeitpunkten; und
- eine Steuereinheit (16), eingerichtet zum Bestimmen eines Werts einer Kapazität (C) des Lastzweigs anhand einer Höhe des Vorladestroms (I), den mindestens zwei gemessenen Werten der Ausgangsspannung (U_{A}) und einer Zeitdifferenz (dt) zwischen den mindestens zwei verschiedenen Messzeitpunkten.

12. Vorladevorrichtung (10) nach Anspruch 11, weiter aufweisend ein Strommessmodul zum Messen einer Höhe des Vorladestroms (I).

13. Vorladevorrichtung (10) nach Anspruch 11 oder 12, aufweisend ein weiteres Spannungsmessmodul (14) zum Messen von einer Höhe einer Eingangsspannung (U_{E}), wobei die Steuereinheit (16) weiter dazu eingerichtet ist, einen internen oder externen Überbrückungsschalter (19) anzusteuern, der parallel zu dem Strombegrenzer (11) geschaltet ist.

14. Vorladevorrichtung (10) nach einem der Ansprüche 11 bis 13, bei dem der Strombegrenzer (11) im Hinblick auf die Höhe des Vorladestroms (I) von der Steuereinheit (16) ansteuerbar ist, wobei die Steuereinheit (16) dazu eingerichtet ist, die Höhe des Vorladestroms (I) abhängig von dem bestimmten Wert der Kapazität (C) einzustellen.
